# EUROPEAN PATENT APPLICATION

(11) **EP 2 180 521 A1**
(43) Date of publication of application: **28.04.2010**
(21) Application number: 08790732.5
(22) Date of filing: 30.06.2008
(51) Int. Cl.: H01L 31/042

(54) **SOLAR CELL MODULE**

(30) Priority: 07.08.2007 JP 2007205681
(71) Applicant: Sharp Kabushiki Kaisha, Osaka-shi, Osaka 545-8522 (JP)
(72) Inventor: FUNAKOSHI, Yasushi, Osaka-shi, Osaka 545-8522 (JP)
(74) Representative: Müller - Hoffmann & Partner
(86) International application number: PCT/JP2008/061819
(87) International publication number: WO 2009/019940

(57) **Abstract**

There is provided a solar cell module, comprising a solar cell structure formed by electrically connecting a plurality of solar cell strings including a substrate (111) on which a wiring (109, 110) for electrically connecting solar cells (100) to each other is placed and a plurality of solar cells (100) placed on the wiring (109, 110) of the substrate (111) and electrically connected. The solar cell structure is placed with a portion of the substrate (111) at at least one of opposing ends of the solar cell structure folded to a side opposite to a light receiving surface side of the solar cells (100). Each of the solar cell strings has a bus bar portion (114, 115) that is a part of the wiring (109, 110), on the folded portion of the substrate (111). The plurality of solar cell strings are electrically connected by electrically connecting the bus bar portion (114, 115) to another bus bar portion (114, 115).

## Description

### TECHNICAL FIELD

The present invention relates to a solar cell module, and in particular, to a solar cell module that can deal with thinning of a solar cell, whose power generation efficiency and properties can be enhanced, and furthermore, that can be easily fabricated at low cost.

### BACKGROUND ART

In recent years, it has been desired to develop clean energy because of global environmental problems and the like such as exhaustion of energy resources and an increase in CO₂ in the atmosphere. In particular, the photovoltaic power generation using solar cells has been developed, put to practical use and is progressing as a new energy source.

Conventionally, a solar cell has been a mainstream that is manufactured by diffusing impurities, whose conductivity type is opposite to that of a monocrystalline or polycrystalline silicon substrate, over a surface (light receiving surface) of the silicon substrate on the side on which solar light falls and forming a pn junction near the light receiving surface, and in addition, by arranging one electrode on the light receiving surface and the other electrode on a surface (back surface) located on the side opposite to the light receiving surface.

A plurality of solar cells configured as described above are electrically connected by an interconnector to form a solar cell string, and the solar cell string is sealed with a resin to fabricate a solar cell module for the photovoltaic power generation.

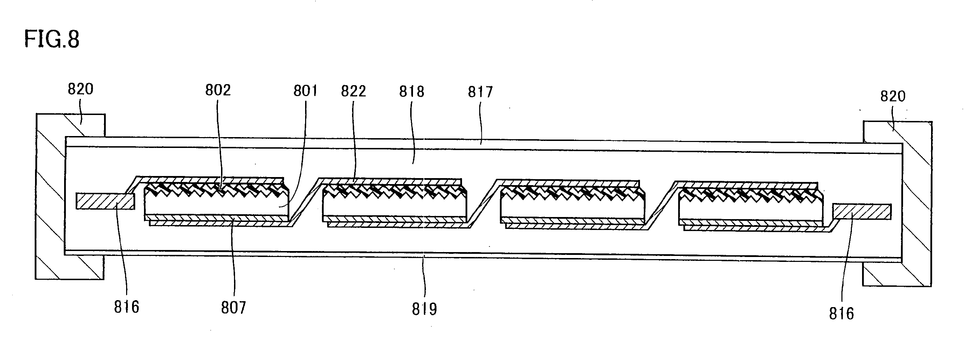

Fig. 8 shows a schematic cross-sectional view of an example of a conventional solar cell module. The conventional solar cell module has a configuration in which a solar cell is fabricated by forming a light receiving surface side electrode (not shown), together with an antireflection film 802, on a light receiving surface on which a texture structure of a silicon substrate 801 is formed and forming a back surface side electrode 807 on a back surface, and the solar cells are connected by an interconnector 822 to form a solar cell string, and the solar cell string is sealed into a transparent resin 818. In addition, a glass substrate 817 is placed on an upper surface of transparent resin 818 that seals the solar cell string, and a weather-resistant film 819 is placed on a lower surface, and the periphery thereof is surrounded by an aluminum frame 820. Moreover, a connecting member 816 for electrically connecting the solar cell string to another solar cell string is provided at interconnector 822 at each of opposing ends of the solar cell string.

Although the photovoltaic power generation system now becomes widespread gradually, the power generation cost is higher than that of the thermal power generation and the like, and therefore, it is strongly requested to reduce the power generation cost in order to further encourage the widespread use.

First of all, a method for reducing the power generation cost includes a method for reducing the material cost. Secondly, the method includes a method for enhancing the power generation efficiency of the solar cell module. In other words, if the power generation efficiency can be enhanced at the same material cost, the power generation cost can be relatively reduced.

If the silicon substrate is thinned in order to reduce the material cost, however, the solar cell is thinned as the silicon substrate is thinned, and a crack may occur in the solar cell during the operation of wiring the solar cell with the interconnector when the solar cell module is fabricated.

In addition, as shown in Fig. 8, when the light receiving surface side electrode (not shown) of the solar cell is connected to back surface side electrode 807 of another solar cell by interconnector 822, a space is required to pass interconnector 822 between the solar cells, and furthermore, the space requires a certain degree of size in order to lighten a load applied to an end of the solar cell. Therefore, the filling ratio of the solar cell within the solar cell module is lowered, which is, in turn, responsible for a decrease in the power generation efficiency of the solar cell module.

In addition, in recent years, the development of a so-called back electrode type solar cell having both an electrode for a first conductivity type and an electrode for a second conductivity type (i.e., an electrode for the p type and an electrode for the n type) on a back surface of a silicon substrate has been advancing. Through the use of this back electrode type solar cell, the cells can be connected to each other only on the back surface side of the cells.

Even in the back electrode type solar cell, however, there are problems related to the occurrence of a crack in the back electrode type solar cell due to thinning of the silicon substrate, and the enhancement of the power generation efficiency of the solar cell module.

Thus, in Japanese Patent Laying-Open No. 2005-340362 (Patent Document 1), a method for connecting a back electrode type solar cell to a wiring substrate is proposed in order to prevent a crack in the back electrode type solar cell and enhance the F. F of a solar cell module. In Japanese Patent Laying-Open No. 2007-19334 (Patent Document 2), a method for connecting a back electrode type solar cell to a wiring substrate is proposed in order to prevent a crack in the back electrode type solar cell.
Patent Document 1: Japanese Patent Laying-Open No. 2005-340362
Patent Document 2: Japanese Patent Laying-Open No. 2007-19334

### DISCLOSURE OF THE INVENTION

### PROBLEMS TO BE SOLVED BY THE INVENTION

In the method in Patent Document 1, however, it is not attained to enhance the power generation efficiency of the solar cell module by enhancing the filling ratio of the back electrode type solar cell within the solar cell module.

In addition, in the method in Patent Document 2, it is required to fabricate a solar cell module by performing complicated steps of connecting the wiring substrate to one back electrode type solar cell, and then, further connecting each back electrode type solar cell having the wiring substrate connected thereto to each other. Moreover, although it is proposed to increase the filling ratio of the back electrode type solar cell within the solar cell module by using a printed substrate provided with a throughhole to connect the back electrode type solar cells, an idea of increasing the filling ratio of the back electrode type solar cell without decreasing the F. F of the solar cell module is not attained. Furthermore, a double-sided printed substrate provided with the throughhole is very expensive from the viewpoint of using it in the solar cell module, and is not suitable for use in a commercially available solar cell module.

In view of the above circumstances, an object of the present invention is to provide a solar cell module that can deal with thinning of a solar cell, whose power generation efficiency and properties can be enhanced, and furthermore, that can be easily fabricated at low cost.

### MEANS FOR SOLVING THE PROBLEMS

The present invention is directed to a solar cell module, comprising a solar cell structure formed by electrically connecting a plurality of solar cell strings including a substrate on which a wiring for electrically connecting solar cells to each other is placed and a plurality of solar cells placed on the wiring of the substrate and electrically connected, the solar cell structure being placed with a portion of the substrate at at least one of opposing ends of the solar cell structure folded to a side opposite to a light receiving surface side of the solar cells, each of the solar cell strings having a bus bar portion that is a part of the wiring, on the folded portion of the substrate, and the plurality of solar cell strings being electrically connected by electrically connecting the bus bar portion to another bus bar portion.

In the solar cell module of the present invention, at least the part of the wiring preferably includes at least one type selected from the group consisting of copper, aluminum and silver.

In addition, in the solar cell module of the present invention, the bus bar portion that is the part of the wiring preferably includes at least one type selected from the group consisting of silver, copper and aluminum.

The present invention is directed to a solar cell module, comprising a solar cell structure including a substrate on which a wiring for electrically connecting solar cells to each other is placed and a plurality of solar cells placed on the wiring of the substrate and electrically connected, the solar cell structure being placed with a portion of the substrate at at least one of opposing ends of the solar cell structure folded to a side opposite to a light receiving surface side of the solar cells.

In addition, in the solar cell module of the present invention, a length before the folding of the solar cell structure in a connection direction of the solar cells is preferably longer than a length of a light receiving portion of the solar cell module in the connection direction of the solar cells.

In addition, in the solar cell module of the present invention, the substrate is preferably formed of a flexible substrate including at least one type selected from the group consisting of polyethylene terephthalate, polyethylene naphthalate, polyimide, and ethylene vinyl acetate.

In addition, in the solar cell module of the present invention, the substrate is preferably folded by using a bar made of an insulating material as an axis.

In addition, in the solar cell module of the present invention, the wiring preferably has an opening for determining at least one of a position for placement of the bar and a position for the folding of the substrate.

Furthermore, in the solar cell module of the present invention, each of the solar cells is preferably a back electrode type solar cell comprising an electrode for a p type and an electrode for an n type on a back surface opposite to the light receiving surface side of the solar cells.

### EFFECTS OF THE INVENTION

According to the present invention, there can be provided a solar cell module that can deal with thinning of a solar cell, whose power generation efficiency and properties can be enhanced, and furthermore, that can be easily fabricated at low cost.

### BRIEF DESCRIPTION OF THE DRAWINGS

Fig. 1 is a schematic cross-sectional view of an example of a solar cell module of the present invention.
Fig. 2 is a schematic plan view of a back surface of a back electrode type solar cell shown in Fig. 1.
Fig. 3 is a schematic plan view of a wiring substrate shown in Fig. 1.
Fig. 4 is a schematic cross-sectional view of a solar cell string configured by electrically connecting the back electrode type solar cell having the back surface shown in Fig. 2 to the wiring substrate shown in Fig. 3.
Fig. 5 is a schematic plan view of an example of a solar cell structure used in the present invention.
Fig. 6 is a schematic plan view of another example of the solar cell structure used in the present invention.
Fig. 7 is a schematic cross-sectional view for illustrating an example of a method for manufacturing the solar cell module shown in Fig. 1.
Fig. 8 is a schematic cross-sectional view of an example of a conventional solar cell module.

### DESCRIPTION OF THE REFERENCE SIGNS

100 back electrode type solar cell; 101, 801 silicon substrate; 102, 802 antireflection film; 103 passivation film; 104 n-type region; 105 p-type region; 106 electrode for the n type; 107 electrode for the p type; 108 conductive material; 109 wiring for the n type; 110 wiring for the p type; 111 wiring substrate; 112 slit; 113 connecting electrode; 114 bus bar p electrode; 115 bus bar n electrode; 116 conductive member; 117 transparent substrate; 118, 818 transparent resin; 119 base material; 120 frame body; 121 bar; 122 bus bar electrode portion; 807 back surface side electrode; 816 connecting member; 817 glass substrate; 819 weather-resistant film; 820 aluminum frame; 822 interconnector

### BEST MODES FOR CARRYING OUT THE INVENTION

Embodiments of the present invention will be described hereinafter. In the drawings of the present invention, the same reference characters designate the same or corresponding portions.

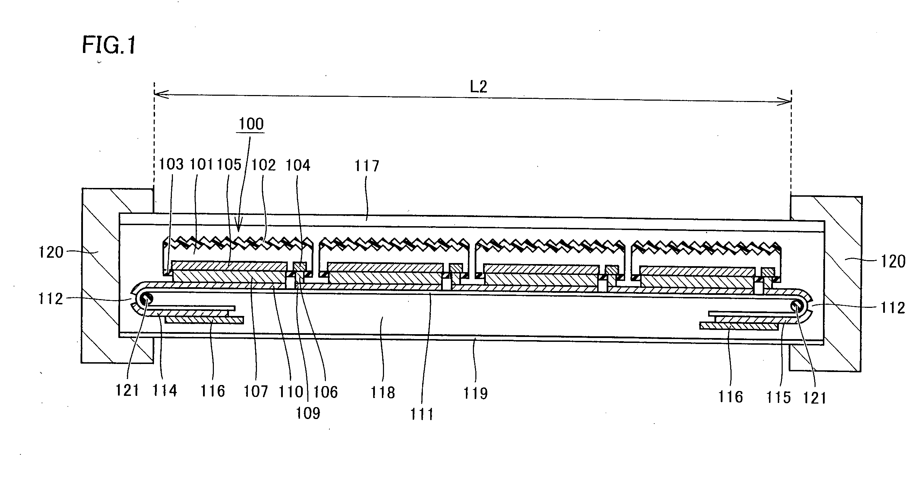

Fig. 1 shows a schematic cross-sectional view of an example of a solar cell module of the present invention. In the solar cell module of the present invention, an n-type region 104 and a p-type region 105 are formed, respectively, on an exposed surface from a passivation film 103 formed on a back surface of, for example, a p-type or n-type silicon substrate 101. The solar cell module of the present invention has a back electrode type solar cell 100 having a configuration in which an electrode for the n type 106 is formed on n-type region 104, and an electrode for the p type 107 is formed on p-type region 105, and an antireflection film 102 is formed on a light receiving surface of silicon substrate 101. It is noted that the light receiving surface of silicon substrate 101 has a texture structure.

Electrode for the n type 106 and electrode for the p type 107 of back electrode type solar cell 100 are electrically connected to a wiring for the n type 109 and a wiring for the p type 110 placed on a wiring substrate 111, respectively. By electrically connecting electrode for the n type 106 of one back electrode type solar cell of adjacent back electrode type solar cells to electrode for the p type 107 of the other back electrode type solar cell, the adjacent back electrode type solar cells are serially connected to configure a solar cell string.

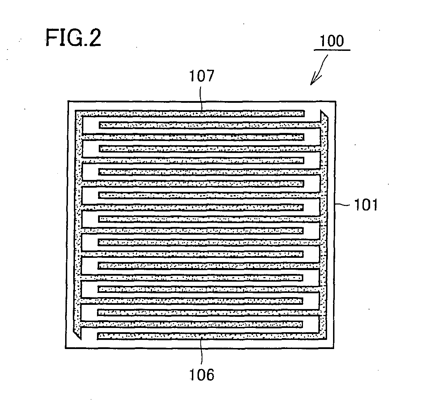

Fig. 2 shows a schematic plan view of the back surface of back electrode type solar cell 100 shown in Fig. 1. Each of electrode for the n type 106 and electrode for the p type 107 is formed in the shape of a comb on the back surface of silicon substrate 101, and electrode for the n type 106 and electrode for the p type 107 are placed such that teeth of the respective combs are engaged in an alternate manner. Each of electrode for the n type 106 and electrode for the p type 107 is preferably made of a metal material, and in particular, of a material including silver.

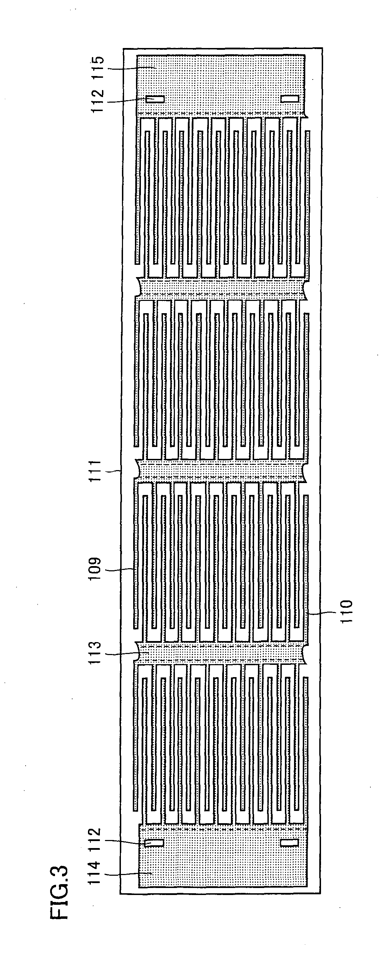

Fig. 3 shows a schematic plan view of wiring substrate 111 shown in Fig. 1. On the surface of wiring substrate 111, wiring for the n type 109 and wiring for the p type 110 are provided, and in addition, a connecting electrode 113 for electrically connecting wiring for the n type 109 that is electrically connected to electrode for the n type 106 of back electrode type solar cell 100 and wiring for the p type 110 that is electrically connected to electrode for the p type 107 is provided.

In addition, a bus bar p electrode 114 for collecting power is electrically connected to wiring for the p type 110 placed at one end in the longitudinal direction of wiring substrate 111, and a bus bar n electrode 115 for collecting power is electrically connected to wiring for the n type 109 placed at the other end.

Furthermore, a slit 112 serving as an opening for positioning is formed in each of bus bar p electrode 114 and bus bar n electrode 115.

It is preferable to use, as wiring substrate 111, a flexible film of at least one type selected from the group consisting of PET (polyethylene terephthalate), PEN (polyethylene naphthalate), polyimide, and ethylene vinyl acetate.

In addition, it is preferable to use, as wiring for the n type 109, wiring for the p type 110, connecting electrode 113, bus bar p electrode 114, and bus bar n electrode 115, a metal material including at least one type selected from the group consisting of silver, copper and aluminum.

It is noted that, although the respective regions of wiring for the n type 109, wiring for the p type 110, connecting electrode 113, bus bar p electrode 114, and bus bar n electrode 115 are separated by a dashed line in Fig. 3, the present invention is not limited to the separation shown in Fig. 3.

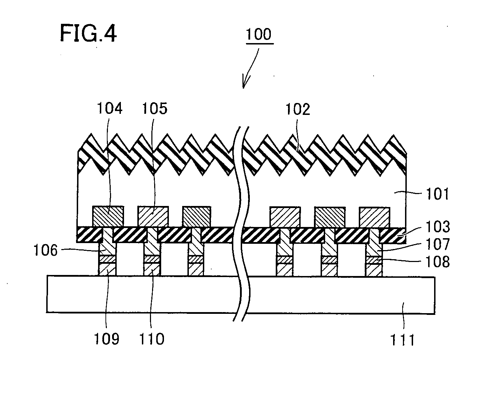

Fig. 4 shows a schematic cross-sectional view of the solar cell string configured by electrically connecting back electrode type solar cell 100 having the back surface shown in Fig. 2 to wiring substrate 111 shown in Fig. 3. Electrode for the n type 106 of back electrode type solar cell 100 is electrically connected to wiring for the n type 109 on wiring substrate 111 with a conductive material 108 interposed therebetween, and electrode for the p type 107 of back electrode type solar cell 100 is electrically connected to wiring for the p type 110 on wiring substrate 111 with conductive material 108 interposed therebetween. For example, solder, a conductive adhesive and the like can be used as the conductive material.

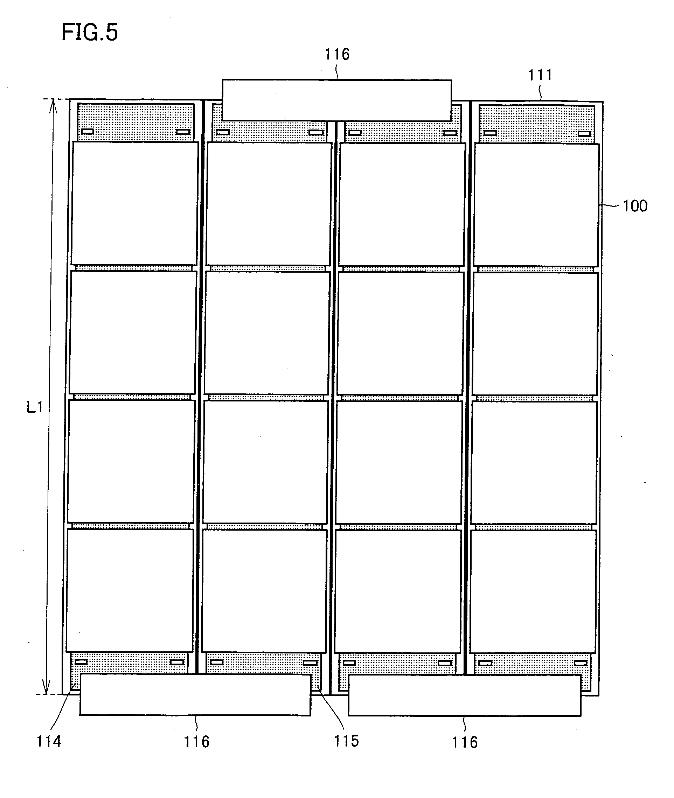

Fig. 5 shows a schematic plan view of an example of a solar cell structure used in the present invention. The solar cell structure is configured by electrically connecting, with a conductive member 116, bus bar p electrode 114 of one solar cell string to bus bar n electrode 115 of the other solar cell string of adjacent solar cell strings that are configured by electrically connecting back electrode type solar cell 100 having the back surface shown in Fig. 2 to wiring substrate 111 shown in Fig. 3.

In the solar cell structure configured as shown in Fig. 5, the solar cell strings formed by electrically connecting the plurality of back electrode type solar cells 100 on wiring substrate 111 are electrically connected to each other. Therefore, there are advantages that handling of the individual solar cell strings is easy, that a small reflow furnace is enough for the connection between back electrode type solar cells 100 and wiring substrate 111 by using the solder, the conductive adhesive and the like, as well as that temperature control and workability are easy.

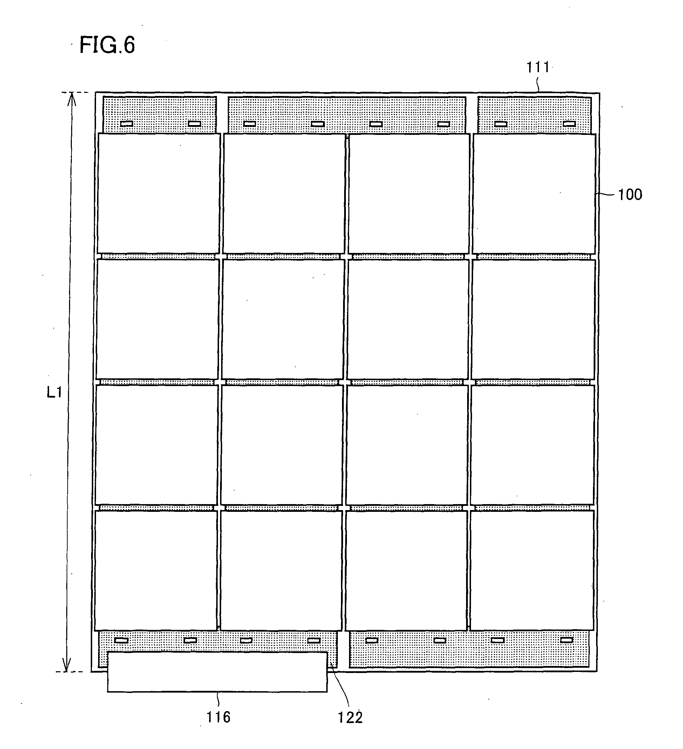

In order to avoid a decrease in the F. F (Fill Factor) of the solar cell module, it is preferable to increase the cross-sectional area of the wiring material, and in particular, it is important to increase the cross-sectional areas of bus bar p electrode 114 of a solar cell string and bus bar n electrode 115 of the other solar cell string as well as conductive member 116, in the solar cell structure shown in Fig. 5 (the same is applied as well to Fig. 6).

Fig. 6 shows a schematic plan view of another example of a solar cell structure used in the present invention. The solar cell structure is configured by placing a plurality of back electrode type solar cells 100 having the back surfaces shown in Fig. 2 on one wiring substrate 111 on which the wiring for the p type and the wiring for the n type are formed, and electrically connecting the plurality of back electrode type solar cells 100.

In the solar cell structure configured as shown in Fig. 6, only one wiring substrate 111 is used. Therefore, there is an advantage that it is not necessary to electrically connect wiring substrates 111 to each other.

In addition, in the solar cell structure shown in Fig. 6, conductive member 116 may be electrically connected to a bus bar electrode portion 122 serving as a portion where the connection direction of back electrode type solar cells 100 is reversed as shown in Fig. 6, in order to reduce the electrical resistance of the solar cell structure.

It is noted that conductive member 116 shown in Figs. 5 and 6 is not particularly limited as long as a member made of a material having conductivity is used. For example, a conventionally known interconnector and the like that have been used in the field of solar cells can be used.

The solar cell structure is sealed in a state where portions of wiring substrate 111 where bus bar p electrode 114 and bus bar n electrode 115 are formed, at opposing ends in the connection direction of back electrode type solar cells 100 of the solar cell structure configured as described above are folded to the side opposite to the light receiving surface side of back electrode type solar cell 100, and as a result, the solar cell module shown in Fig. 1 is obtained.

At this time, each of the opposing ends in the connection direction of back electrode type solar cells 100 of the solar cell structure is folded by using an insulating bar 121 as an axis, and the solar cell structure is sealed into a transparent resin 118 such as EVA between a transparent substrate 117 made of, for example, glass and the like and a base material 119 formed of a weather-resistant film and the like. Then, a frame body 120 such as aluminum is put on to surround the periphery of transparent substrate 117, transparent resin 118 and base material 119 that seal the solar cell structure, and as a result, the solar cell module shown in Fig. 1 is obtained.

As described above, the solar cell structure is sealed in a state where the ends of wiring substrate 111 where bus bar portions such as bus bar p electrode 114 and bus bar n electrode 115 are formed are folded to the side opposite to the light receiving surface side of back electrode type solar cell 100. Therefore, flexibility in designing the bus bar portions and conductive member 116 is increased, and the width and the cross-sectional area of the bus bar portions and conductive member 116 can be increased in order to reduce the series resistance between the solar cell strings. Thus, a decrease in the F. F at the time of fabrication of the solar cell module can be suppressed, and a solar cell module having a high F. F can be fabricated.

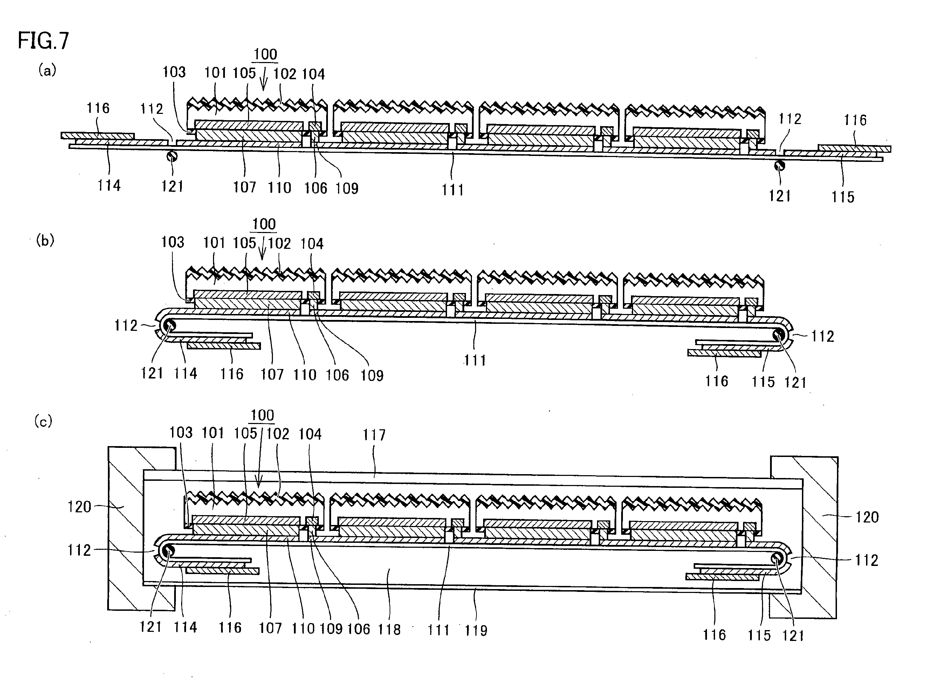

An example of a method for manufacturing the solar cell module shown in Fig. 1 will be described hereinafter with reference to the schematic cross-sectional views in Figs. 7(a) to (c).

First, as shown in Fig. 7(a), the solar cell structure configured as shown in Fig. 5 or 6 is fabricated by using the above method, and insulating bar 121 is placed under slit 112 formed at each of the opposing ends of the solar cell structure. A bar having a diameter of about 1 to 2 mm and made of an insulating material such as acrylic can be used as insulating bar 121. In addition, in order to suppress the occurrence of a crack in back electrode type solar cell 100, it is preferable to place bar 121 outside of back electrode type solar cell 100 that is arranged at the end in the connection direction of back electrode type solar cells 100, as shown in Fig. 7(a), for example. Moreover, it is preferable to form slit 112 having such a size that does not affect the resistance of the wiring on wiring substrate 111.

Next, as shown in Fig. 7(b), the portion of wiring substrate 111 at each of the opposing ends of the solar cell structure is folded to the side opposite to the light receiving surface side of back electrode type solar cell 100 by using bar 121 as the axis.

Generally, when the solar cell structure is sealed into transparent resin 118 and the like and the periphery thereof is clamped by frame body 120, a portion having a width of, for example, about 5 to 10 mm from a perimeter of transparent substrate 117 is covered with frame body 120 and forms a shadow that does not contribute to power generation (a portion of the light receiving surface of the solar cell module except for the shadow formed by frame body 120 serves as a light receiving portion of the solar cell module).

Accordingly, in order to eliminate waste of the filling ratio of back electrode type solar cell 100 within the light receiving surface of the solar cell module, it is preferable to place the solar cell structure such that the perimeter portion (e.g., bar 121 and a part of the bus bar portion) except for back electrode type solar cell 100 of the solar cell structure after wiring substrate 111 is folded is located within the shadow formed by frame body 120, that is, such that the portion except for back electrode type solar cell 100 is not exposed at the light receiving portion of the solar cell module as much as possible.

The configuration has been described here in which bar 121 is placed such that the portion of slit 112 is set as a folding position, and the portion of wiring substrate 111 at each of the opposing ends of the solar cell structure is folded by using bar 121 as the axis. In the present invention, however, the portion of wiring substrate 111 at each of the opposing ends of the solar cell structure may be folded to the side opposite to the light receiving surface side of back electrode type solar cell 100 by using the portion of slit 112 as the folding position and without placing bar 121. If the portion of wiring substrate 111 is folded without using bar 121, a fold of the folded portion may have an acute angle and the wiring may be broken. Folding the portion of wiring substrate 111 by using bar 121 as the axis leads to lessening of a load applied to the folded portion. Therefore, it is preferable to fold the portion of wiring substrate 111 by using bar 121 as the axis. It is noted that bar 121 may be removed or left as it is when the solar cell structure is sealed.

Thereafter, as shown in Fig. 7(c), the solar cell structure is sealed into transparent resin 118 between transparent substrate 117 such as glass and base material 119 such as the weather-resistant film in a state where the portions of wiring substrate 111 at the opposing ends of the solar cell structure are folded to the side opposite to the light receiving surface side of back electrode type solar cell 100, and frame body 120 made of aluminum and the like is put onto the periphery. As a result, the solar cell module configured as shown in Fig. 1 is fabricated.

In the solar cell module fabricated as described above, a length L1 before folding of the solar cell structure in the connection direction of back electrode type solar cells 100 of the solar cell structure shown in, for example, Fig. 5 or 6 (in Figs. 5 and 6, for example, the vertical direction of the papers of Figs. 5 and 6) may be made longer than a length L2 of the light receiving portion of the solar cell module in the connection direction of back electrode type solar cells 100 shown in Fig. 1, in order to increase the width of the wiring to reduce the resistance of the connection between the solar cell strings, and the like.

Even in such a case, in the present invention, the solar cell structure is sealed in a state where the portions of wiring substrate 111 at the opposing ends of the solar cell structure are folded to the side opposite to the light receiving surface side of back electrode type solar cell 100, and as a result, the solar cell module is fabricated. Therefore, the filling ratio can be enhanced, which is a ratio of the total area of the light receiving surface of back electrode type solar cell 100 to the area of the light receiving portion of the solar cell module. Thus, the power generation efficiency of the solar cell module can be enhanced. In addition, in the present invention, the resistance of the connection between the solar cell strings can be reduced by increasing the width of the wiring of wiring substrate 111. Therefore, the properties of the solar cell module such as the F. F can also be enhanced.

In addition, in the present invention, the electrical connection is possible by placing wiring substrate 111 on the back surface of back electrode type solar cell 100, and it is not necessary to route the interconnector from the light receiving surface to the back surface as in the conventional connection of the solar cells. Therefore, a load applied to back electrode type solar cell 100 at the time of fabrication of the solar cell module is reduced, and the occurrence of a crack in back electrode type solar cell 100 is reduced. Accordingly, according to the present invention, a load applied to back electrode type solar cell 100 at the time of fabrication of the solar cell module can be reduced, and therefore, thinning of back electrode type solar cell 100 can be dealt with.

Furthermore, in the present invention, it is not necessary to provide one wiring substrate 111 for each back electrode type solar cell 100. Therefore, the fabrication of the solar cell module can be facilitated.

It is noted that, in the specification, a surface of the back electrode type solar cell and the solar cell module on which solar light falls is defined as a light receiving surface, and a surface opposite to the light receiving surface is defined as a back surface.

In addition, in the present invention, it is preferable to use, as the solar cell, the back electrode type solar cell in which both of the electrode for the p type and the electrode for the n type are formed on the back surface of the semiconductor substrate such as the silicon substrate, as described above.

In addition, in the above, it has been described that both of the opposing ends in the connection direction of back electrode type solar cells 100 of the solar cell structure are folded. In the present invention, however, any one of the opposing ends in the connection direction of back electrode type solar cells 100 of the solar cell structure may be folded. It is preferable, however, to fold both of the opposing ends in the connection direction of back electrode type solar cells 100 of the solar cell structure, in order to enhance the filling ratio of back electrode type solar cell 100 in the solar cell module.

In addition, in the present invention, a semiconductor substrate except for the silicon substrate may be used, and the p and n conductivity types may be interchanged.

### Example

First, back electrode type solar cell 100 having the back surface configured as shown in Fig. 2 is prepared. The back surface of back electrode type solar cell 100 is a square having a length of one side of 100 mm, and comb-shaped electrode for the n type 106 and electrode for the p type 107 are formed such that the respective electrodes in the shape of the teeth of the combs face each other and are alternately arranged one by one.

A copper foil having a thickness of 18 µm is formed on the entire surface of wiring substrate 111 formed of a film of PEN, and then, a part of the copper foil is removed by etching to have a shape shown in Fig. 3, and wiring for the n type 109, wiring for the p type 110, connecting electrode 113, bus bar p electrode 114, and bus bar n electrode 115 formed of the copper foil left on wiring substrate 111 are formed. Thus, the wiring is formed to be capable of electrically connecting four back electrode type solar cells 100 in series.

Connecting electrode 113 is designed such that the distance between adjacent back electrode type solar cells 100 is set to 1 mm. In addition, the copper foil outside of slit 112 is designed to be set to 50 mm.

Next, as shown in Fig. 4, by using the reflow furnace, electrode for the n type 106 of back electrode type solar cell 100 is electrically connected to wiring for the n type 109 on wiring substrate 111 with conductive material 108 made of solder interposed therebetween, and in addition, electrode for the p type 107 is electrically connected to wiring for the p type 110 on wiring substrate 111 with conductive material 108 made of solder interposed therebetween, to form the solar cell string in which back electrode type solar cells 100 are serially connected.

Next, as shown in Fig. 5, four solar cell strings fabricated as described above are prepared and serially connected by using the interconnector as conductive member 116 to fabricate the solar cell structure. In order to avoid a load applied to back electrode type solar cell 100 when wiring substrate 111 at the opposing ends of the solar cell structure is folded, a thin and wide member that is obtained by coating, with solder, the copper foil having a thickness of 0.08 mm and a width of 30 mm to sufficiently increase the cross-sectional area is used as conductive member 116 implemented as the interconnector.

Thereafter, an EVA (ethylene vinyl acetate) sheet is placed on transparent substrate 117 made of glass, and the above solar cell structure is placed thereon such that the light receiving surface side of back electrode type solar cell 100 faces downward. As shown in Fig. 7(a), bar 121 made of acrylic and having a diameter of 1.5 mm is placed at the position of slit 112.

Thereafter, as shown in Fig. 7(b), the portion of wiring substrate 111 of the solar cell structure outside of slit 112 is folded to the side opposite to the light receiving surface side of back electrode type solar cell 100 by using bar 121 as the axis, and the EVA sheet and base material 119 formed of the weather-resistant film are placed thereon. The EVA sheet stacked by vacuum heating is further heated to crosslink the EVA, and as a result, the solar cell structure is sealed into transparent resin 118 made of the EVA.

Finally, the periphery of the stack of base material 119, transparent resin 118 and transparent substrate 117 is clamped by frame body 120 to fabricate the solar cell module configured as shown in Fig. 1. At this time, a shadow portion having a width of 10 mm from the perimeter of transparent substrate 117 is formed in the solar cell module. In addition, a portion that is located outside of back electrode type solar cell 100 when wiring substrate 111 is folded back has a width of 5 mm. Moreover, clamping by frame body 120 is performed such that the distance between frame body 120 and back electrode type solar cell 100 that is closest to frame body 120 is set to 2 mm.

The solar cell module fabricated as described above has a very high filling ratio of back electrode type solar cell 100 with respect to the light receiving portion of the solar cell module. Therefore, the high power generation efficiency of the solar cell module is obtained. In addition, since the series resistance due to the wiring between the solar cell strings can be lowered, the excellent F. F of the solar cell module can be obtained.

Furthermore, the fabrication of the solar cell module fabricated as described above is easy, and thinning of back electrode type solar cell 100 can be dealt with.

It should be understood that the embodiments disclosed herein are illustrative and not limitative in any respect. The scope of the present invention is defined by the terms of the claims, rather than the above description, and is intended to include any modifications within the scope and meaning equivalent to the terms of the claims.

### INDUSTRIAL APPLICABILITY

According to the present invention, there can be provided a solar cell module that can deal with thinning of a solar cell, whose power generation efficiency and properties can be enhanced, and furthermore, that can be easily fabricated.

## Claims

1. A solar cell module, comprising a solar cell structure formed by electrically connecting a plurality of solar cell strings including a substrate (111) on which a wiring (109, 110) for electrically connecting solar cells (100) to each other is placed and a plurality of solar cells (100) placed on said wiring (109, 110) of said substrate (111) and electrically connected,
said solar cell structure being placed with a portion of said substrate (111) at at least one of opposing ends of said solar cell structure folded to a side opposite to a light receiving surface side of said solar cells (100),
each of said solar cell strings having a bus bar portion (114, 115) that is a part of said wiring (109, 110), on said portion of said substrate (111) folded, and
said plurality of solar cell strings being electrically connected by electrically connecting said bus bar portion (114, 115) to another said bus bar portion (114, 115).

2. The solar cell module according to claim 1, wherein
at least the part of said wiring (109, 110) includes at least one type selected from the group consisting of copper, aluminum and silver.

3. The solar cell module according to claim 1, wherein
said bus bar portion (114, 115) includes at least one type selected from the group consisting of silver, copper and aluminum.

4. The solar cell module according to claim 1, wherein
a length before said folding of said solar cell structure in a connection direction of said solar cells (100) is longer than a length of a light receiving portion of said solar cell module in the connection direction of said solar cells (100).

5. The solar cell module according to claim 1, wherein
said substrate (111) is a flexible substrate (111) including at least one type selected from the group consisting of polyethylene terephthalate, polyethylene naphthalate, polyimide, and ethylene vinyl acetate.

6. The solar cell module according to claim 1, wherein
said substrate (111) is folded by using a bar (121) made of an insulating material as an axis.

7. The solar cell module according to claim 6, wherein
said wiring (109, 110) has an opening (112) for determining at least one of a position for placement of said bar (121) and a position for said folding of said substrate (111).

8. The solar cell module according to claim 1, wherein
each of said solar cells (100) is a back electrode type solar cell (100) comprising an electrode for a p type (107) and an electrode for an n type (106) on a back surface opposite to the light receiving surface side of said solar cells (100).

9. A solar cell module, comprising a solar cell structure including a substrate (111) on which a wiring (109, 110) for electrically connecting solar cells (100) to each other is placed and a plurality of solar cells (100) placed on said wiring (109, 110) of said substrate (111) and electrically connected,
said solar cell structure being placed with a portion of said substrate (111) at at least one of opposing ends of said solar cell structure folded to a side opposite to a light receiving surface side of said solar cells (100).

10. The solar cell module according to claim 9, wherein
a length before said folding of said solar cell structure in a connection direction of said solar cells (100) is longer than a length of a light receiving portion of said solar cell module in the connection direction of said solar cells (100).

11. The solar cell module according to claim 9, wherein
said substrate (111) is a flexible substrate including at least one type selected from the group consisting of polyethylene terephthalate, polyethylene naphthalate, polyimide, and ethylene vinyl acetate.

12. The solar cell module according to claim 9, wherein
said substrate (111) is folded by using a bar (121) made of an insulating material as an axis.

13. The solar cell module according to claim 12, wherein
said wiring (109, 110) has an opening for determining at least one of a position for placement of said bar (121) and a position for said folding of said substrate (111).

14. The solar cell module according to claim 9, wherein
each of said solar cells (100) is a back electrode type solar cell comprising an electrode for a p type (107) and an electrode for an n type (106) on a back surface opposite to the light receiving surface side of said solar cells (100).
